# EUROPEAN PATENT APPLICATION

(11) **EP 2 071 586 A1**
(43) Date of publication of application: **17.06.2009**
(21) Application number: 08826879.2
(22) Date of filing: 18.08.2008
(51) Int. Cl.: H01B 5/14, C23C 14/08, H01B 13/00

(54) **TRANSPARENT CONDUCTIVE FILM AND METHOD FOR PRODUCING TRANSPARENT CONDUCTIVE FILM**

(30) Priority: 05.09.2007 JP 2007230347
(71) Applicant: Murata Manufacturing Co. Ltd., Kyoto 617-8555 (JP)
(72) Inventor: FUKAHORI, Souko, Nagaokakyo-shi Kyoto 617-8555 (JP); KISHIMOTO, Yutaka, Nagaokakyo-shi Kyoto 617-8555 (JP)
(74) Representative: Thoma, Michael
(86) International application number: PCT/JP2008/064708
(87) International publication number: WO 2009/031399

(57) **Abstract**

The following film and method are provided: a ZnO-based transparent conductive film which has humidity resistance sufficient for practical use and properties necessary for transparent conductive films and which is cost-effective and a method of producing the ZnO-based transparent conductive film.

A transparent conductive film (ZnO layer) made of ZnO has a configuration in which a ZnO layer includes a region having a granular crystal structure.

The zinc oxide layer is doped with a group-III element. The dose of the group-III element is 0.8 to 11.5 weight percent on an oxide mass basis. The group-III element is at least one selected from the group consisting of Ga, Al, and In.

The full width at half maximum of a ZnO (002) rocking curve is preferably 10.5 degrees or less.

A substrate is rested while the ZnO layer is being formed on the substrate.

The zinc oxide layer is formed in such a manner that a target is supplied with pulsed DC power.

## Description

### Technical Field

The present invention relates to transparent conductive films and methods of producing the transparent conductive films. The present invention particularly relates to a transparent conductive film made of zinc oxide (ZnO) and a method of producing the transparent conductive film.

### Background Art

In recent years, transparent electrodes have been widely used in flat panel displays and solar cells. The transparent electrodes are usually made of ITO (indium tin oxide).

However, indium (In) is expensive and its resources seem to be exhausted. Therefore, there are increasing demands for transparent electrodes made of other materials. ZnO-based transparent electrodes, which are In-free transparent electrodes, are being developed because the ZnO-based transparent electrodes are made of the oxide (ZnO) of zinc (Zn), which is inexpensive and stably available.

Although stoichiometric ZnO is an insulator, excess electrons due to oxygen defects and element replacement (doping) at a Zn site allow ZnO to be conductive. The following electrodes can be prepared at present: transparent electrodes which are made of such ZnO and which have a resistivity p in the order of 10⁻⁴ Ωcm.

Conventional ZnO-based transparent conductive films have a problem in that the moisture resistance thereof is insufficient for practical use. That is, the conventional ZnO-based transparent conductive films contain a large number of oxygen defects and therefore have a problem in that the adsorption of moisture of the oxygen defects (reoxidation of the oxygen defects) reduces the number of carriers to cause an increase in resistance if the ZnO-based transparent conductive films are left in high-humidity environments. One of standards for the humidity resistance of an ITO transparent electrode is that the change in resistance of the ITO transparent electrode is ±10% after the ITO transparent electrode is left in an atmosphere with a relative humidity of 85% at 85°C for 720 h. However, no ZnO-based transparent conductive films meeting this standard have been obtained.

If a ZnO-based transparent conductive film is formed on a flexible substrate, which may be used for various applications, there is a problem in that the transparent conductive film is seriously deteriorated by moisture because the flexible substrate is permeable to moisture and therefore not only the moisture present on a surface of the transparent conductive film but also the moisture passing through the flexible substrate affect the transparent conductive film.

In order to solve the problems, various techniques for enhancing the moisture resistance of ZnO-based transparent conductive films have been investigated. The techniques are roughly categorized into the following two groups:
(1) techniques for preventing moisture from passing through substrates using SiN barrier layers and
(2) techniques for improving the quality (crystallinity) of ZnO films by heating.
   However, no ZnO-based transparent conductive film with moisture resistance sufficient to for practical use has been obtained yet.

Proposed techniques for imparting conductivity to ZnO by element doping are as described below.

(a) A technique in which the electrical resistance of a ZnO film is reduced with high controllability in such a manner that the ZnO film is doped with an impurity using a molecular beam of a group-IA element (H), a group-IIIA element (B, Al, Ga, or In), or a group-VIIA element (F, Cl, I, or Br) when the ZnO film is prepared using a molecular beam of ZnO or molecular beams of Zn and O (refer to Patent Document 1).

(b) A transparent conductive body which contains ZnO doped with a group-VB or -VIB element in the periodic table and which includes a substrate and a transparent conductive film containing the element, the transparent conductive film being disposed on the substrate, the number of atoms of the element being 0.1% to 10% of the sum of the number of the element atoms and that of zinc atoms (refer to Patent Document 2).

(c) An organic EL element which includes a substrate, an anode disposed on the substrate, a cathode, and an organic layer disposed between the anode and the cathode and in which the anode includes a transparent conductive film made of a material containing one or more of oxides of Ir, Mo, Mn, Nb, Os, Re, Ru, Rh, Cr, Fe, Pt, Ti, W, and V (refer to Patent Document 3).

(d) A transistor including a transparent conductive material, such as conductive ZnO, doped or undoped with any one of group-II, -VII, -I, and -V elements (refer to Patent Document 4).

(e) A transparent conductive film prepared by doping a zinc oxide thin film, having a c-axis/a-axis orientation ratio of 100 : 1 or more, with at least one of group- VII and - III compounds containing aluminum, gallium, or boron (refer to Patent Document 5).

(f) An indium zinc oxide hexagonal layered compound which is represented by the formula (ZnO)m·In₂O₃ (m = 2 to 20), in which In or Zn is replaced with at least one selected from the group consisting of Sn, Y, Ho, Pb, Bi, Li, Al, Ga, Sb, Si, Cd, Mg, Co, Ni, Zr, Hf, Sc, Yb, Lu, Fe, Nb, Ta, W, Te, Au, Pt, and Ge, and which has an average thickness of 0.001 to 0.3 µm and an average aspect ratio (average major diameter/average thickness) of three to 1000 (refer to Patent Document 6).

Known ZnO films which are formed by depositing zinc oxide particles prepared by oxidizing zinc particles generated by sputtering and which have columnar crystal structures (refer to Patent Document 7). Patent Document 7 discloses that the ZnO films each have a columnar crystal structure shown in Fig. 8 or 9 thereof. The reason why common ZnO films usually have a columnar crystal structure is probably that the (002) plane of a ZnO hexagonal crystal is extremely energetically stable and grains grow primarily at the (002) plane thereof.

The known ZnO-based transparent conductive films have the above problems relating to moisture resistance.

Under these circumstances, the present applicant has found that the crystal structure of ZnO has a significant effect on humidity resistance. The present applicant has proposed a transparent conductive film prepared by growing zinc oxide (ZnO) heavily doped with a group-III element on a substrate and a method of producing the transparent conductive film (refer to Patent Document 8). The transparent conductive film is different in configuration from that according to the present invention, is heavily doped with an impurity, has c-axes extending in different directions, and is excellent in humidity resistance.
Patent Document 1: Japanese Unexamined Patent Application Publication No. 7-106615
Patent Document 2: Japanese Unexamined Patent Application Publication No. 8-050815
Patent Document 3: Japanese Unexamined Patent Application Publication No. 11-067459
Patent Document 4: Japanese Unexamined Patent Application Publication No. 2000-150900
Patent Document 5: Japanese Unexamined Patent Application Publication No. 2000-276943
Patent Document 6: WO 2001/056927
Patent Document 7: Japanese Unexamined Patent Application Publication No. 2006-5115
Patent Document 8: WO 2007/080738

### Disclosure of Invention

### Problems to be Solved by the Invention

The present invention has been made under the above circumstances. It is an object of the present invention to provide a ZnO-based transparent conductive film which is obtained by a method different from an impurity heavily doping method, which has humidity resistance sufficient for practical use and properties necessary for transparent conductive films, and which is cost-effective and to provide a method of producing the ZnO-based transparent conductive film.

### Means for Solving the Problems

In order to solve the above problems, the inventors have formed various films by varying conditions using targets containing group-III elements. The inventors have found that a ZnO layer having a granular crystal structure different from a common columnar crystal structure is excellent in humidity resistance. The inventors have further performed experiments and investigations and have then completed the present invention.
A transparent conductive film according to the present invention (Claim 1) includes a zinc oxide (ZnO) layer grown on a substrate. The zinc oxide layer includes a region having a granular crystal structure.

In the transparent conductive film according to present invention, the zinc oxide layer is doped with a group-III element as described in Claim 2.

In the transparent conductive film according to present invention, the dose of the group-III element is 0.8 to 11.5 weight percent on an oxide mass basis as described in Claim 3.

In the transparent conductive film according to present invention, the full width at half maximum of a ZnO (002) rocking curve is preferably 10.5 degrees or less as described in Claim 4.

In the transparent conductive film according to present invention, the substrate is made of at least one selected from the group consisting of glass, quartz, sapphire, Si, SiC, polyethylene terephthalate (PET), polyethylene naphthalate (PEN), polyethersulfone (PES), polyimide, cycloolefinic polymers, and polycarbonate as described in Claim 5.

In the transparent conductive film according to present invention, the group-III element is at least one selected from the group consisting of Ga, Al, and In as described in Claim 6.

### Advantages

A transparent conductive film according to the present invention includes a zinc oxide layer having a granular crystal structure. The transparent conductive film is grown on a substrate. This allows the transparent conductive film to have excellent humidity resistance and prevents the resistivity thereof from being deteriorated with time. A transparent conductive film having good humidity resistance stable properties can be obtained in such a manner that a ZnO layer is formed on a glass substrate by growing a granular crystal. The resistivity of this transparent conductive film hardly varies after a lapse of 200 hours even if the doping concentration of Al is low, for example, 3.0% by weight.

The zinc oxide layer is doped with a group-III element as described in Claim 2. This can securely provide a ZnO-based transparent conductive film which has humidity resistance sufficient for practical use and which is cost-effective.

The dose of the group-III element is 0.8 to 11.5 weight percent on an oxide mass basis as described in Claim 3. Therefore, the following film can be securely achieved: a practical transparent conductive film which has excellent humidity resistance and of which the resistivity hardly varies with time. This proves the present invention to be effective.

A transparent conductive film is formed in such a manner that the doping concentration of the group-III element is controlled to be low such that the growth of C-axis columnar crystals is prevented and granular crystals are grown. Therefore, the following film can be securely achieved: a practical transparent conductive film which has low resistivity and excellent humidity resistance and of which the resistivity hardly varies with time.
When the dose of the group-III element is less than 0.8 weight percent or greater than 11.5 weight percent on an oxide mass basis, the resistivity is likely to be increased. Therefore, the dose of the group-III element is preferably 0.8 to 11.5 weight percent on an oxide mass basis.

The full width at half maximum of a ZnO (002) rocking curve is preferably 10.5 degrees or less as described in Claim 4. Therefore, resistivity can be maintained low because the crystal orientation in grains is good.

The full width at half maximum of the ZnO (002) rocking curve correlates with the dose of the group-III element. When the dose of the group-III element is greater than 11.5 weight percent on an oxide mass basis, the full width at half maximum of the ZnO (002) rocking curve is greater than 10.5 degrees and resistivity is likely to increase. Therefore, the dose of the group-III element is preferably controlled such that the full width at half maximum of the ZnO (002) rocking curve does not exceed 10.5 degrees.

In the transparent conductive film according to present invention, the substrate is made of at least one selected from the group consisting of glass, quartz, sapphire, Si, SiC, polyethylene terephthalate (PET), polyethylene naphthalate (PEN), polyethersulfone (PES), polyimide, cycloolefinic polymers, and polycarbonate as described in Claim 5. The substrate can be used to form a ZnO-based transparent conductive film thereon. The ZnO-based transparent conductive film has humidity resistance sufficient for practical use and is cost-effective.

The group-III element is at least one selected from the group consisting of Ga, Al, and In as described in Claim 6. Therefore, the following film can be securely achieved: a ZnO-based transparent conductive film which has humidity resistance sufficient for practical use and which is cost-effective.

In view of achieving sufficiently low resistivity, the group-III element (doping element) is most preferably Al or Ga. The use of In, which is another group-III element, is effective in achieving an advantage similar to that achieved by the use of Al or Ga.

### Brief Description of Drawings

[Fig. 1] Fig. 1 is a schematic view of an off-axis sputtering system used to form a ZnO layer, serving as a transparent conductive film, in an example (Example 1) of the present invention.
[Fig. 2] Fig. 2 is a SEM image illustrating the crystal structure (a structure in which granular crystals are grown) of the ZnO layer (transparent conductive film) according to Example 1.
[Fig. 3] Fig. 3 is a SEM image illustrating the crystal structure (a structure in which columnar crystals are grown) of a ZnO layer (transparent conductive film) according to a comparative example.
[Fig. 4] Fig. 4 is a graph illustrating the temporal change in resistivity of each ZnO layer according to Example 1 and that of each ZnO layer according to the comparative example.
[Fig. 5] Fig. 5 is a graph illustrating the relationship between the dose of a group-III element and the resistivity of each ZnO layer.
[Fig. 6] Fig. 6 is a graph illustrating the relationship between the dose of a group-III element and the full width at half maximum (FWHM) of the ZnO (002) rocking curve of each ZnO layer.

### Reference Numerals

- 1: deposition chamber
- 2: holder (substrate holder)
- 3: target
- 4: shutter

### Best Modes for Carrying Out the Invention

A transparent conductive film according to the present invention and a method of producing the transparent conductive film will now be described in detail.

At first, the method of producing the transparent conductive film which includes a zinc oxide (ZnO) layer is described. The transparent conductive film is produced by using an off-axis sputtering system.

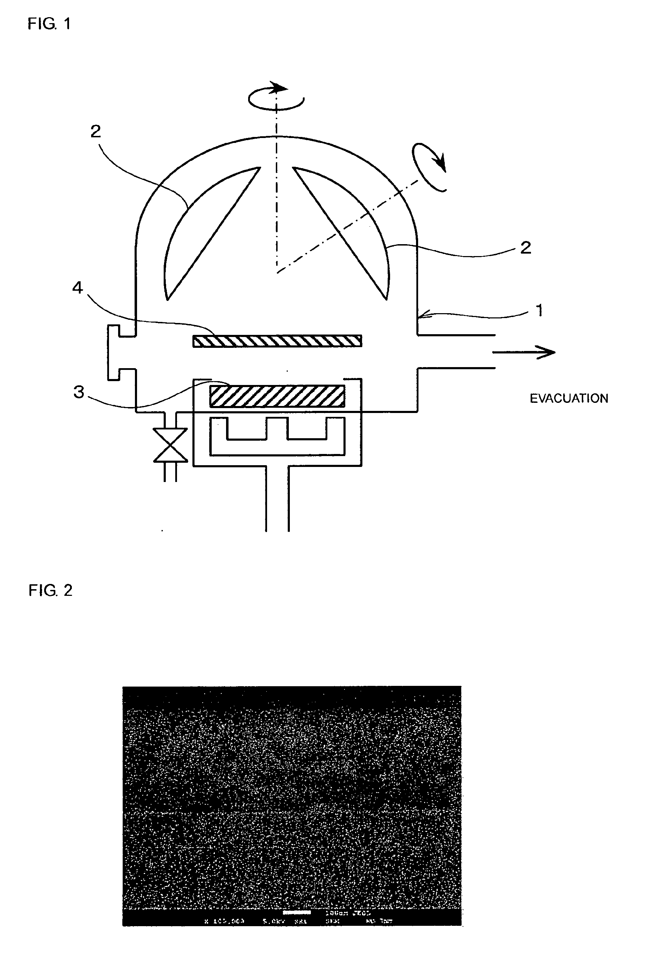

Fig. 1 shows the schematic configuration of the off-axis sputtering system.

The off-axis sputtering system includes a deposition chamber 1, a holder (substrate holder) 2 which is placed in the deposition chamber 1 and which holds a substrate (not shown) to be coated with the ZnO layer, a target 3 placed in the deposition chamber 1, and a shutter 4 placed between the target 2 and the substrate, which is held with the holder 2. The deposition chamber 1 is configured such that the deposition chamber 1 can be evacuated and the target 3 can be supplied with pulsed DC power.

The off-axis sputtering system is configured such that the layer can be formed in such a state that the substrate, which has a surface for growing the layer, is placed outside a space which is located in the direction perpendicular to the target and in which high-energy particles come with high probability. The off-axis sputtering system is capable of forming the layer in such a manner that the composition of the layer is controlled such that the layer composition hardly differs from the composition of the target.

The target 3 has a sintered density of 80% or more, a two-dimensional size of 315 mm × 118 mm, and a thickness of 5 mm.
The substrate is made of at least one selected from the group consisting of glass, quartz, sapphire, Si, SiC, polyethylene terephthalate (PET), polyethylene naphthalate (PEN), polyethersulfone (PES), polyimide, cycloolefinic polymers, and polycarbonate. Even if the substrate is made of any one of the above materials, the substrate is surface-cleaned in advance of deposition in such a manner that the substrate is washed with isopropyl alcohol and irradiated with UV light.

The substrate is set in the deposition chamber 1 of the off-axis sputtering system and the deposition chamber 1 is then evacuated to 5.5 × 10⁻⁵ Pa.
After evacuation, a high-purity Ar gas used as a sputtering gas is introduced into the deposition chamber 1 such that the pressure therein is increased to a predetermined value.
The target 3 is sputtered in such a manner that a pulsed DC power with a predetermined pulse width is applied to the target 3 at a predetermined frequency.

The thickness of a layer obtained by sputtering is set to 400 nm. The obtained ZnO layer is patterned by wet etching and then measured for thickness with a probe profilometer, whereby the ZnO layer is checked whether the ZnO layer has a set thickness. The ZnO layer is analyzed for composition, whereby the ZnO layer is checked whether the composition thereof is the same as that of the target. Layers prepared in examples or comparative examples each had a thickness substantially equal to a set thickness and the difference of the composition of each layer from that of a target was on an acceptable level.
Variable sputtering conditions are principally the composition of the target (the type and dose of a group-III element), the type of the substrate, the pressure in the chamber, the rotation speed of the substrate, a pulsed DC power, a pulse width, and a pulse frequency.

### EXAMPLE 1

Fig. 2 is a cross-sectional SEM image of an Al-doped ZnO (AZO) layer, according to Example 1, having a granular crystal structure. The ZnO layer was prepared under conditions below.
Target: ZnO-mixed sintered body containing 3.0 weight percent Al₂O₃
Type of substrate: alkali-free glass (Corning 1737) Pressure in chamber: 0.1 Pa
Rotation of substrate: not rotated
Pulsed DC power: 2000 W
Pulse width: 2 µs
Pulse frequency: 100 kHz
The following layer was confirmed to have a granular crystal structure: a Ga-doped ZnO (GZO) layer, which is not shown, prepared using a ZnO-mixed sintered body containing 5.7 weight percent Ga₂O₃ used as a target.

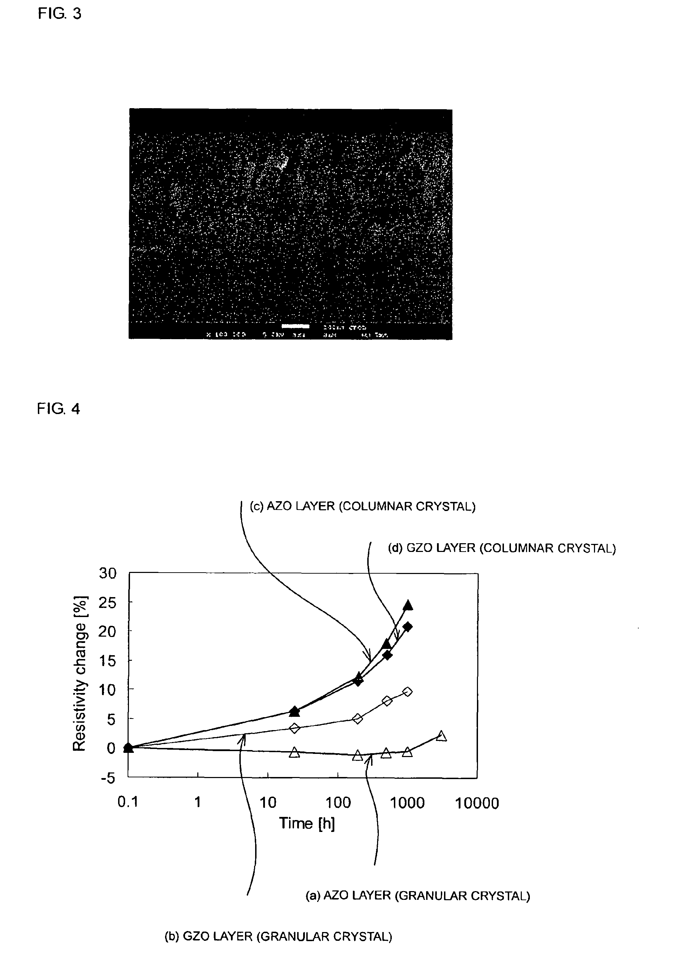

A ZnO layer having a conventional columnar crystal structure was obtained under conditions partially different from the above conditions, for example, under such a condition that a substrate was rotated at 10 rpm. Fig. 3 is a cross-sectional SEM image of an Al-doped ZnO (AZO) layer, according to a comparative example, having a columnar crystal structure. A Ga-doped ZnO (GZO) layer, which is not shown, was confirmed to have a columnar crystal structure.

As described above, it is found that slight changes in production conditions allow the obtained ZnO layers to have different crystal structures. However, it has not been sufficiently clear that what mechanism interrupts crystal growth on the (002) plane, which is extremely stable, to create a granular crystal structure.

### [Resistivity of ZnO layer]

The ZnO layers according to the example and the comparative example were measured for resistivity by a four-probe technique.
(1) Resistivity of ZnO layer according to Example 1
   The resistivity of each ZnO layer formed as described above was confirmed to be a value below.
   Resistivity of Al-doped ZnO (AZO) layer: 9.9 × 10⁻⁴ Ωcm
   Resistivity of Ga-doped ZnO (GZO) layer: 7.1 × 10⁻⁴ Ωcm
(2) Resistivity of ZnO layer according to Comparative Example
   The resistivity of each ZnO layer formed in the comparative example as described above was confirmed to be a value below.
   Resistivity of Al-doped ZnO (AZO) layer: 9.3 × 10⁻⁴ Ωcm
   Resistivity of Ga-doped ZnO (GZO) layer: 7.9 × 10⁻⁴ Ωcm

### [Sheet resistance]

The ZnO layers according to the example and the comparative example were measured for sheet resistance.
(1) Sheet resistance of ZnO layer according to Example 1
   The sheet resistance of each ZnO layer formed in Example 1 as described above was confirmed to be a value below.
   Sheet resistance of Al-doped ZnO (AZO) layer: 27 Ω/square
   Sheet resistance of Ga-doped ZnO (GZO) layer: 19 Ω/square
(2) Sheet resistance of ZnO layer according to Comparative Example
   The sheet resistance of each ZnO layer formed in the comparative example as described above was confirmed to be a value below.
   Sheet resistance of Al-doped ZnO (AZO) layer: 23 Ω/square
   Sheet resistance of Ga-doped ZnO (GZO) layer: 19 Ω/square

### [Transmittance at visible wavelengths]

The ZnO layers according to the example and the comparative example were measured for transmittance at visible wavelengths. All the ZnO layers were confirmed to have a transmittance of 80% or more at visible wavelengths.

### [Change in resistivity with time]

The ZnO layers according to Example 1 and Comparative Example, that is, the following layers were measured for change in resistivity with time in an atmosphere with a relative humidity of 85% at 85°C:
(a) the Al-doped ZnO (AZO) layer including the granular crystalline region,
(b) the Ga-doped ZnO (GZO) layer including the granular crystalline region,
(c) the Al-doped ZnO (AZO) layer including the columnar crystalline region, and
(d) the Ga-doped ZnO (GZO) layer including the columnar crystalline region.
   The measurement results are shown in Fig. 4.

Fig. 4 confirms that the granular crystalline region-including Al-doped ZnO (AZO) layer specified in Item (a) and the granular crystalline region-including Ga-doped ZnO (GZO) layer specified in Item (b) have a small change in resistivity with time and the columnar crystalline region-including Al-doped ZnO (AZO) layer specified in Item (c) and the columnar crystalline region-including Ga-doped ZnO (GZO) layer specified in Item (d), however, have a large change in resistivity with time.

### EXAMPLE 2

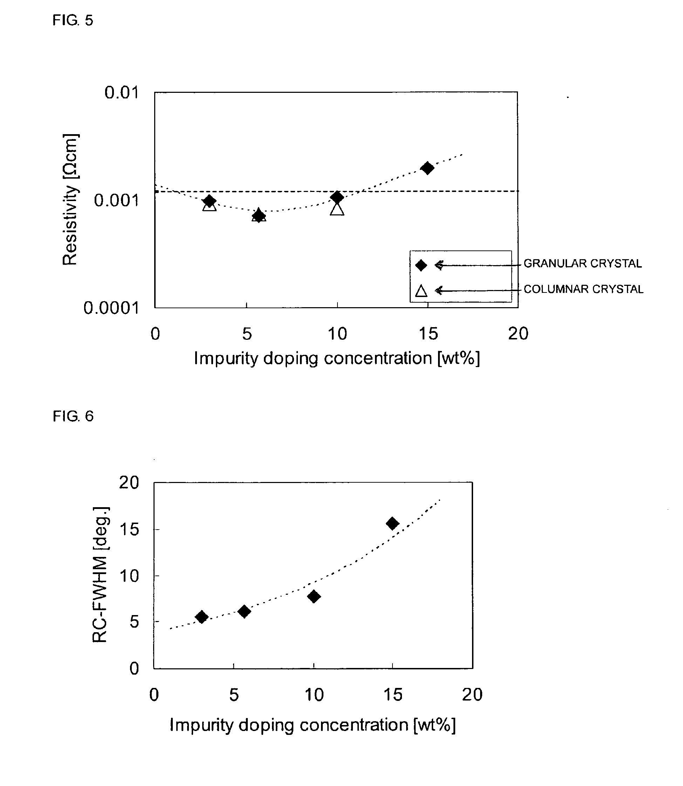

Several types of targets having different Al₂O₃ or Ga₂O₃ contents were prepared. ZnO layers were formed under conditions similar to those described in Example 1 using the targets in such a manner that the dose of each group-III element was varied in four steps: 3.0, 5.7, 10.0, and 15.0 weight percent on an oxide mass basis.
The obtained ZnO layers were used to investigate the relationship between the dose of the group-III element and the resistivity of the ZnO layers. Fig. 5 shows the data obtained using Al, which is a group-III element.

It is commonly known that a ZnO layer, used as a transparent conductive film, for practical use has a resistivity of 1.2 × 10⁻³ Ωcm or less. Fig. 5 confirms that the resistivity is 1.2 × 10⁻³ Ωcm or less when the dose of the group-III element is within a range from 0.8 to 11.5 weight percent.
Therefore, the dose of the group-III element is preferably within a range from 0.8 to 11.5 weight percent on an oxide mass basis.
Fig. 5 shows the data obtained using Al, which is a group-III element. Example 2 confirms that the relationship between the dose of the group-III element and the resistivity of the ZnO layers does not significantly vary even if the group-III element is Al or Ga.
The ZnO layers of Example 2, which are different in the dose of each group-III element from the ZnO layers of Example 1, are confirmed to have the granular crystal structure even if the dose of the group-III element is zero, although the crystal structures are not shown.

### EXAMPLE 3

Several types of targets having different Al₂O₃ or Ga₂O₃ contents were prepared in the same manner as that described in Example 2. ZnO layers were formed under conditions similar to those described in Example 1 using the targets in such a manner that the dose of each group-III element was varied in four steps: 3.0, 5.7, 10.0, and 15.0 weight percent on an oxide mass basis.
The obtained ZnO layers were used to investigate the relationship between the dose of the group-III element and the full width at half maximum (FWHM) of the ZnO (002) rocking curve of each ZnO layer. Fig. 6 shows the data obtained using Al, which is a group-III element.

Example 2 confirms that in order to allow the ZnO layers to have a resistivity suitable for use as transparent conductive films, the dose of the group-III element is preferably within a range from 0.8 to 11.5 weight percent on an oxide mass basis as described above. Example 3 (Fig. 6) confirms that the full width at half maximum (FWHM) of the ZnO (002) rocking curve is preferably 10.5 degrees or less.

Example 3 confirms that in order to allow the ZnO layers to have a resistivity of 1.2 × 10⁻³ Ωcm suitable for use as transparent conductive films, the full width at half maximum (FWHM) of the ZnO (002) rocking curve is preferably 10.5 degrees or less.
Fig. 6 shows the data obtained using Al, which is a group-III element. Example 3 confirms that the relationship between the dose and the full width at half maximum (FWHM) of the ZnO (002) rocking curve of each ZnO layer does not significantly vary even if the group-III element is Al or Ga.

### EXAMPLE 4

Substrates (flexible substrates) made of PEN (polyethylene naphthalate) were used instead of the glass substrate, made of alkali-free glass, used in Example 1. ZnO layers (transparent conductive films) doped with Al or Ga were formed on the flexible substrates under the same conditions as those described in one of Examples 1 to 3 in the same manner as that described in one of Examples 1 to 3.

The obtained ZnO layers (transparent conductive films) were characterized under the same conditions as those described in one of the above examples. This confirmed that the ZnO layers (transparent conductive films) had substantially the same properties as those described in one of Examples 1 to 3.
The ZnO layers (not shown) of Example 4 were confirmed to have a granular crystal structure.
This confirms that a practical transparent conductive film can be formed on a substrate (flexible substrate) made of PEN (polyethylene naphthalate), which is versatile.

### EXAMPLE 5

Substrates (flexible substrates) made of PET (polyethylene terephthalate) were used instead of the glass substrate, made of alkali-free glass, used in Example 1. ZnO layers (transparent conductive films) doped with Al or Ga were formed on the flexible substrates under the same conditions as those described in one of Examples 1 to 3 in the same manner as that described in one of Examples 1 to 3.

The obtained ZnO layers (transparent conductive films) were characterized under the same conditions as those described in one of the above examples. This confirmed that the ZnO layers (transparent conductive films) had substantially the same properties as those described in one of Examples 1 to 3.
The ZnO layers of Example 5 were confirmed to have a granular crystal structure, although the crystal structures are not shown.
This confirms that a practical transparent conductive film can be formed on a substrate (flexible substrate) made of PET (polyethylene terephthalate), which is versatile.

In Examples 1 to 5, the ZnO layers (transparent conductive films) were formed on the glass substrates, the PEN substrates, or the PET substrates. A ZnO layer (transparent conductive film) according to the present invention may be formed on a single-crystalline substrate made of quartz, sapphire, or Si or a substrate made of SiC, polyethersulfone (PES), polyimide, a cycloolefinic polymer, or polycarbonate. The use of such a substrate can provide the same advantages as those obtained by the use of the glass substrates.

The conditions described in Examples 1 to 5 are some of preferred exemplary conditions capable of efficiently growing granular crystals. Among conditions such as a chamber pressure, the dose of a group-III element and the type of a substrate are not dominant conditions in growing granular crystals. Among the conditions fixed through Examples 1 to 5, it is unclear that which condition is dominant. In order to grow granular crystals, overall conditions including several sub-conditions probably need to be optimized. Even if the overall conditions are different from those described in Examples 1 to 5, granular crystals can be probably grown as long as the overall conditions are optimized.

The present invention is not limited to the above examples. The followings may be variously adapted or modified within the scope of the present invention: the shape of a substrate for forming a ZnO layer (transparent conductive film), the type of a material for forming the substrate, the type and dose of a group-III element, and conditions for forming the ZnO layer.

### Industrial Applicability

As described above, according to the present invention, a ZnO-based transparent conductive film can be efficiently and securely produced. The ZnO-based transparent conductive film has humidity resistance sufficient for practical use and properties necessary for transparent conductive films and is cost-effective.
Accordingly, the present invention can be widely used for various applications such as transparent electrodes for flat panel displays or solar cells.

## Claims

1. A transparent conductive film comprising a zinc oxide (ZnO) layer grown on a substrate, wherein the zinc oxide layer includes a region having a granular crystal structure.

2. The transparent conductive film according to Claim 1, wherein the zinc oxide layer is doped with a group-III element.

3. The transparent conductive film according to Claim 2, wherein the dose of the group-III element is 0.8 to 11.5 weight percent on an oxide mass basis.

4. The transparent conductive film according to any one of Claims 1 to 3, wherein the full width at half maximum of a ZnO (002) rocking curve is preferably 10.5 degrees or less.

5. The transparent conductive film according to any one of Claims 1 to 4, wherein the substrate is made of at least one selected from the group consisting of glass, quartz, sapphire, Si, SiC, polyethylene terephthalate (PET), polyethylene naphthalate (PEN), polyethersulfone (PES), polyimide, cycloolefinic polymers, and polycarbonate.

6. The transparent conductive film according to any one of Claims 1 to 5, wherein the group-III element is at least one selected from the group consisting of Ga, Al, and In.
